Europäisches Patentamt

European Patent Office

Office européen des brevets

(19)

(11) Numéro de publication : **0 277 165 B1**

(12) **FASCICULE DE BREVET EUROPEEN**

(45) Date de publication du fascicule du brevet :
**15.01.92 Bulletin 92/03**

(51) Int. Cl.⁵ : **G01R 33/48**

(21) Numéro de dépôt : **87904895.7**

(22) Date de dépôt : **28.07.87**

(86) Numéro de dépôt international :
**PCT/FR87/00299**

(87) Numéro de publication internationale :
**WO 88/01381 25.02.88 Gazette 88/05**

(54) **PROCEDE D'APPLICATION DES IMPULSIONS DE GRADIENT DANS UNE EXPERIMENTATION D'IMAGERIE AU MOYEN D'UNE MACHINE DE RESONANCE MAGNETIQUE NUCLEAIRE.**

(30) Priorité : **14.08.86 FR 8611730**

(43) Date de publication de la demande :
**10.08.88 Bulletin 88/32**

(45) Mention de la délivrance du brevet :
**15.01.92 Bulletin 92/03**

(84) Etats contractants désignés :
**DE GB NL**

(56) Documents cités :
**EP-A- 0 132 975**
**EP-A- 0 216 523**
**EP-A-00 764 00**

(56) Documents cités :
**JP-A- 6 184 549**
**Patent Abstracts of Japan, vol. 8, no.**
**196(P-290) (1633), 8 September 1984 & JP A**
**5983039**

(73) Titulaire : **GENERAL ELECTRIC CGR S.A.**
**100, rue Camille-Desmoulins**
**F-92130 Issy les Moulineaux (FR)**

(72) Inventeur : **BRETON, Eric**
**29, rue des Saules**
**F-78960 Voisins-les-Bretonneux (FR)**

(74) Mandataire : **Schmit, Christian Norbert Marie**
**et al**
**Cabinet Ballot-Schmit 7, rue Le Sueur**
**F-75116 Paris (FR)**

EP 0 277 165 B1

## Description

La présente invention a pour objet un procédé d'application des impulsions de gradient dans une expérimentation d'imagerie au moyen dune machine de résonance magnétique nucléaire (RMN). Elle trouve son application particulièrement dans le domaine médical où les techniques d'imagerie par RMN servent d'aide aux diagnostics. Elle peut néanmoins trouver son application dans d'autres domaines, notamment dans le domaine industriel pour les contrôles non destructifs.

On connaît le phénomène de la résonance magnétique nucléaire et le principe de fonctionnement des machines d'imagerie qui sont basés sur ce phénomène. Le signal de RMN est dépendant, en chaque lieu de la zone d'intérêt dune telle machine, du champ orientateur de cette machine. Pour faire apparaître le phénomène on excite un corps à examiner avec une excitation radiofréquence. On peut mesurer un signal de désexcitation des particules du corps quand elles retournent à leur équilibre, quand leur moment magnétique se réoriente avec le champ orientateur à la fin de leur basculement dépendant de l'excitation. L'excitation est appliquée à la totalité du corps soumis à l'examen, et toutes les particules du corps pourraient emettre un signal de désexcitation à son issue. En fait la naissance de ce phénomène est cantonnée à des tranches sélectionnées du corps par une modification locale des conditions de résonance apportée par un codage magnétique supplémentaire dit de sélection.

La modification des conditions locales de résonance s'obtient en augmentant, ou en diminuant, l'intensité du champ orientateur dans la tranche sélectionnée. Pour des raisons scientifiques et technologiques il n'est pas possible de modifier brutalement l'intensité d'un champ magnétique continu de part et d'autre dune tranche de l'espace. La modification de champ prend alors la forme d'une variation régulière en fonction de l'abscisse des lieux de l'espace sur un axe perpendiculaire à la tranche à sélectionner. L'intensité du champ orientateur subit donc selon cet axe un gradient. Pratiquement les champs supplémentaires, additionnés aux champs constants et homogènes dans tout l'espace pour provoquer cette variation, sont communément appelés les gradients de champs.

Pour créer une image dune tranche sélectionnée il est aussi nécessaire de soumettre le signal de précession libre résultant de l'excitation à d'autres codages supplémentaires avant et pendant sa mesure. Les codages supplémentaires appliqués avant la mesure sont appelés les codages de phase. En une série de séquences successsives on modifie, d'une séquence à l'autre, le codage ainsi apporté. On interprète les variations qu'il en résulte dans le signal mesuré pour discriminer les paramètres de l'image comme si elle était projetée sur un axe parallèle à celui suivant lequel sont appliqués ces codages de phase. Au cours de la lecture du signal de désexcitation on applique de plus un autre codage sous la forme d'un gradient dit de lecture. Ce codage tend à modifier la fréquence de résonance du phénomène de résonance en fonction de l'amplitude du champ magnétique supplémentaire ainsi apporté. Il en résulte qu'il est aussi possible d'effectuer dans le signal reçu une discrimination en fréquence montrant, à chaque séquence, le résultat de la projection de l'image sur un autre axe, parallèle à l'axe du gradient de lecture. Par échantillonnage du signal de lecture à chacune des séquences de la série on obtient un ensemble d'échantillons qui forme une matrice. Le calcul de la transformée de Fourier suivant les lignes puis suivant les colonnes de la matrice des échantillons, ou inversement, permet d'obtenir l'image. Cette image correspond à celle de la tranche sélectionnée par application du gradient de sélection. Ce mode d'imagerie nécessite que les gradients soient pulsés : ils sont administrés par des impulsions de gradient.

Traditionnellement des bobines magnétiques pour appliquer des impulsions de gradient sont réalisées sur les machines de telle manière qu'elles provoquent l'application de gradients de champ orientés fixement par rapport à la machine. Ces orientations sont généralement distribuées selon trois axes orthogonaux dont un est parallèle au champ orientateur (z) de la machine. Soient X, Y et Z les axes d'imagerie de la machine, il est possible d'affecter les fonctions de sélection, de codage de phase, et de lecture, respectivement à chacun de ces trois axes pour définir dans le corps les images transverses, sagittales, ou frontales. Plus généralement il a même été envisagé d'effectuer des images obliques. En théorie la réalisation de ces images ne pose pas de difficultés particulières. Des procédés pour obtenir des images obliques sont notamment décrits dans les documents EP-A-0216523 (date de priorité :27.08.85, date de publication 01.04.87) et EP-A-0076400.

Dans la pratique la réalisation des images obliques n'est pas si simple. En effet, les impulsions de gradient de sélection, de codage de phase, et de lecture ont des formes propres qu'il est possible d'intervertir (pour charger la fonction des axes d'imagerie de la machine), mais qu'il est difficile d'associer du fait même de la variété des formes et la variation du codage. En particulier comme évoqué précédemment le codage de phase change dune séquence à l'autre de la série. Aussi la combinaison sur un axe d'imagerie de la machine dune impulsion de codage de phase avec une impulsion de lecture et/ou une impulsion de sélection revient alors à définir des formes complexes des impulsions de gradient. Ceci est d'autant plus vrai que les impulsions de codage de phase sont variables dans le temps. On en arrive par exemple à devoir réaliser des impulsions dont la forme générale est un escalier à au moins deux marches et dont une des marches a une hauteur variable dune séquence à une autre. Les alimentations des bobines de gradient peuvent difficilement être programmées pour accomplir ces tâches. Il en résulte que les praticiens n'utilisent pas, au détriment de la qualité de leur diagnostic, les images obliques.

La présente invention a pour objet de remédier aux inconvénients cités en imposant aux impulsions des gradients de champ des formes et des durées d'application identiques. La répartition et la programmation des différentes impulsions sur les axes d'imagerie de la machine n'affectent alors que leur intensité.

L'invention a pour objet un procédé d'application des impulsions de gradient dans une expérimentation d'imagerie au moyen dune machine de RMN, caractérisé en ce qu'il comporte les étapes suivantes :

– on choisit des formes communes pour des impulsions de gradient devant avoir lieu sensiblement en même temps,

– on choisit des dates communes d'application des diverses impulsions de gradient sur les différents axes de l'image,

– et on répartit les impulsions de gradient relatives à l'image sur les axes d'imagerie de la machine, en fonction des cosinus directeurs de l'inclinaison de l'image par rapport aux axes d'imaginerie de la machine, et suivant une chronologie déterminée par le choix des dates communes.

L'invention sera mieux comprise à la lecture de la description qui suit et à l'examen des figures qui l'accompagnent. Celles-ci ne sont qu'indicatives et nullement limitatives de l'invention. En particulier la description d'une méthode d'imagerie de type 2DFT n'en constitue pas une limitation. Les figures montrent :

– Figure 1, une représentation schématique dune machine d'imagerie par RMN utilisant le procédé de l'invention ;

– Figures 2a à 2g, des diagrammes temporels de signaux radiofréquences et de gradients utilisés dans l'invention.

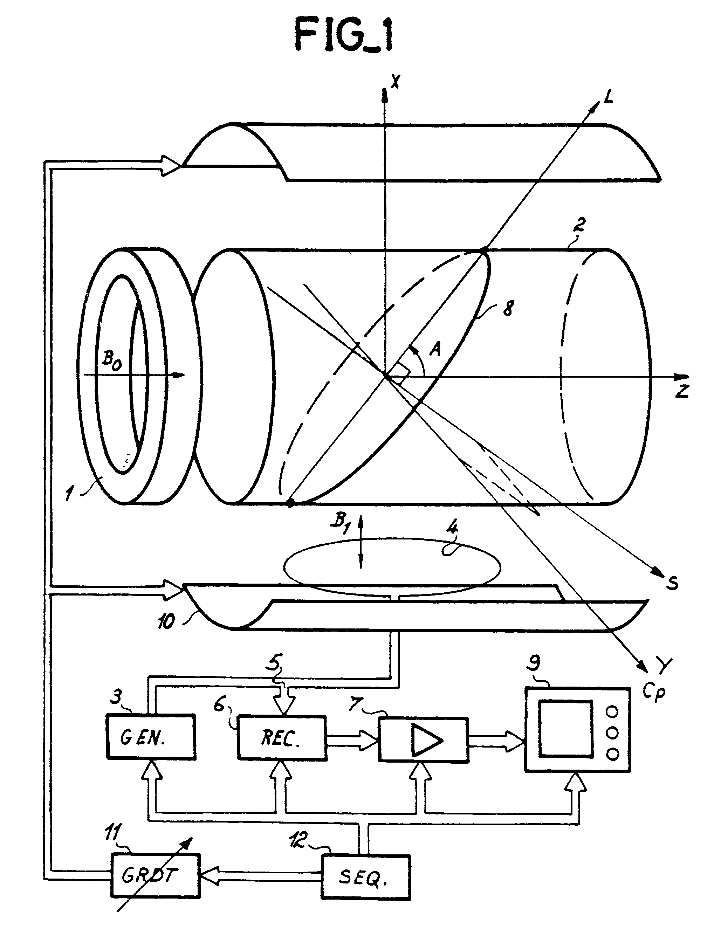

La Figure 1 représente schématiquement une machine d'imaginerie par résonance magnétique nucléaire. Cette machine comporte essentiellement des moyens 1 pour produire un champ magnétique orientateur, constant et homogène, $B_0$ dans un lieu où est placé un corps 2 à examiner. Le corps 2 est soumis à cet endroit à une excitation radiofréquence produite par un générateur 3 en relation avec une antenne 4. L'antenne sert également à prélever le signal de désexcitation et à l'acheminer au moyen d'un duplexeur 5 sur des moyens de réception 6 et de traitement 7 du signal. A l'issue du traitement, l'image dune coupe 8 du corps 2 peut être visualisée sur un dispositif 9 de visualisation. Pour soumettre les moments magnétiques des protons du corps 2 situés dans la tranche 8 au phénomène de résonance, et eux seuls, et pour permettre l'élaboration de l'image on a mis en oeuvre des bobines de gradient 10 alimentées par un générateur 11 d'impulsions de gradient. Tous ces moyens fonctionnent sous le pilotage d'un séquenceur 12.

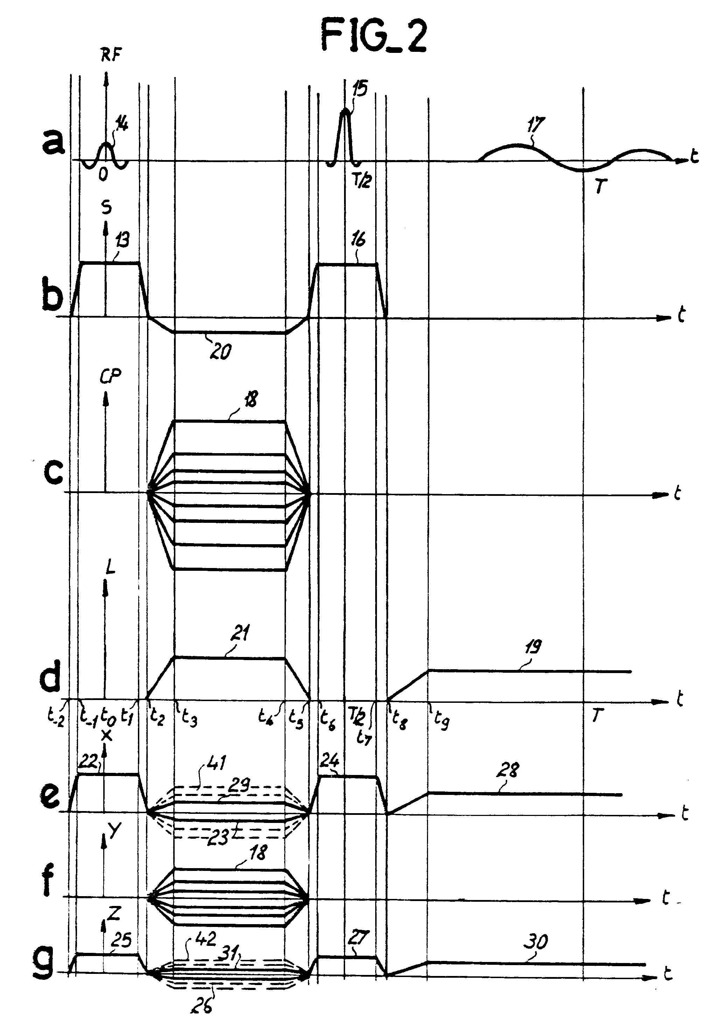

Les Figures 2a à 2d représentent schématiquement et respectivement les signaux radiofréquence d'excitation et de mesure RF, de gradient de sélection S, de codage de phase CP, et de lecture L à appliquer au corps 2 pour pouvoir donner une image dune coupe inclinée d'un angle A (figure 1) par rapport aux axes (orthogonaux) d'imagerie X, Y et Z de la machine. La séquence des signaux représentée correspond à une séquence relative à une méthode d'imagerie du type 2DFT avec écho de spin. Selon cette méthode pendant l'application dune impulsion de gradient de sélection 13 sur un axe S de sélection, on applique une excitation radiofréquence 14 au corps 2. Après une deuxième impulsion 15 radiofréquence, dite à 180°, appliquée de la même façon en présence dune autre impulsion 16 du gradient de sélection de la même tranche 8 (appliquée à une date T/2 après l'application de l'impulsion 14) on peut mesurer autour dune date T le signal 17 de précession libre. Entre les deux excitations radio-fréquence on applique à chaque séquence de la série des séquences, sur un axe CP une impulsion 18 d'un gradient de codage de phase dont l'amplitude, la force, varient dune séquence à l'autre. Au cours de la mesure, de la lecture, du signal de précession libre on applique sur un troisième axe d'image L une impulsion d'un gradient de lecture 19 qui provoque la différenciation en fréquence au moment de la lecture.

De manière à ce que le codage de phase soit seulement le codage apporté sur l'axe CP de codage de phase, il convient de compenser les impulsions de codage appliquées sur les autres axes. En particulier une impulsion 20 d'intégrale sensiblement égale à celle de l'impulsion 13 mais de signe contraire est appliquée à l'issue de cette dernière de manière à en supprimer l'effet parasite. L'impulsion 16 est autocompensée dans la mesure où elle est symétrique en forme et durée autour de la date T/2. De plus l'impulsion de lecture 19 est neutralisée par une impulsion 21 de précodage de lecture dont l'intégrale est sensiblement égale à l'intégrale de la partie de l'impulsion 19 limitée à droite par le temps d'écho T et de même signe qu'elle. Dans l'invention on s'est essentiellement arrangé pour que les impulsions 18, 20 et 21 se produisent entre des dates identiques. On a en plus fait en sorte que ces impulsions aient des formes homothétiques les unes des autres. Il en résulte qu'on a décomposé chaque séquence en un certain nombre de dates prédéterminées au cours desquelles les impulsions de gradient sont sensées être appliquées. Ainsi l'impulsion de sélection 13 est prévue pour être appliquée de la date $t_{-2}$ à la date $t_2$ lors de la première excitation et de la date $t_5$ à la date $t_8$ lors de l'excitation d'écho de spin. De même les impulsions 19, 20 et 21 sont appliquées entre les dates $t_2$ et $t_5$. En outre les impulsions 18, 20 et 21 ont un temps de montée identique compris entre les dates $t_2$ et $t_3$ et un temps de descente identique compris entre les dates $t_4$ et $t_5$. Les seules particularités qui différencient ces impulsions sont dune part les axes sur lesquels elles sont appliquées et d'autre part leurs intensités respectives.

Partant de cette particularité il est possible de répartir simplement les impulsions de sélection, de codage de phase, et de lecture sur chacun des trois axes X, Y et Z d'imagerie de la machine. Dans l'exemple représenté (et uniquement pour simplifier l'explication) on a choisi une tranche 8 oblique passant par l'axe Y de la machine, qui est en même temps l'axe de codage de phase CP. Dans le cas général l'axe CP n'est pas colinéaire à l'axe Y : l'explication qui suit doit être transposée à ce cas où l'invention apporte justement une simplification notable. L'axe de lecture L est lui colinéaire au plan de l'image tout en étant perpendiculaire à l'axe de codage de phase CP. L'axe de sélection S est perpendiculaire à cette image. Il est possible de déterminer en fonction de A l'orientation de l'axe de sélection S par rapport aux axes d'imagerie X et Z. En conséquence les impulsions de sélection 13, 20 et 16 doivent être partagées en impulsions 22 à 24 et 25 à 27 respectivement sur les axes X et Z de la machine. De la même façon les impulsions de lecture 19 et 21 se répartissent en des impulsions 28 et 29, et 30 et 31 respectivement sur les mêmes axes. Dans la mesure où elles sont antagonistes l'une de l'autre, les impulsions 23 et 29, 26 et 31 peuvent éventuellement se simplifier. Les impulsions 18 ont par contre été maintenues sur l'axe d'imagerie Y du fait de l'inclinaison de la tranche 8 recherchée.

En supposant comme c'est généralement le cas que les impulsions 23 et 29, et 26 et 31 ne se neutralisent pas mutuellement, il en résulte que leurs couples donnent naissance à chaque fois à une impulsion de gradient de forme homothétique (au signe près selon le cas) de l'impulsion 20 ou de l'impulsion 21 respectivement. Il en résulte que les moyens nécessaires pour composer ces impulsions de gradient selon les axes d'imagerie de la machine sont les mêmes que ceux qui permettent la réalisation des impulsions de gradients quand les images recherchées ne sont pas obliques par rapport à ces axes d'imagerie : ce sont donc des moyens connus. Seules changent, dune expérimentation à l'autre, les intensitées appliquées. On aboutit alors au résultat particulièrement simple qui consiste à réaliser en trois exemplaires, avec des structures identiques, les moyens d'imposer les différentes impulsions de gradient sur chacun des axes d'imagerie. Or ces moyens, inclus dans le séquenceur, distribuent aux générateurs 11 des instructions programmées, de manière à produire en sortie de ces générateurs des impulsions de gradient de forme et d'amplitude données. Ainsi la répartition de l'impulsion de sélection 13 sur deux axes (ici X et Z), ou sur trois axes dans le cas d'inclinaison quelconque de l'image, rend nécessaire l'exécution de programmes du même type pour agir sur l'application des impulsions sur les mêmes trois axes entre les dates $t_{-2}$ et $t_2$, $t_5$ et $t_8$, et après $t_8$. Dans le même esprit le partage du codage de phase CP entre les trois axes XYZ nécessite aussi trois programmes du même type pour délivrer ces impulsions entre $t_2$ et $t_5$. Tout ceci peut être réalisé simplement en modifiant le logiciel du séquenceur.

On note que la réalisation des images obliques ne nécessite, dans l'invention, que les moyens qu'elle est censée nécessiter dune manière théorique. En effet, avec à la fois des mêmes dates prédéterminées et des mêmes formes des impulsions, seules les intensités des impulsions doivent être déterminées à chaque séquence et pour chaque impulsion. Ces intensités dépendent des cosinus directeurs de l'inclinaison A de l'image par rapport aux axes d'imagerie XYZ de la machine. L'invention présente de plus la particularité que les impulsions ont toutes des mêmes durées de temps de montée ($t_{-2}$ $t_{-1}$ ; $t_2$ $t_3$ et $t_5$ $t_5$) et de descente. Elles sont toutes de forme générale trapezoïdale. Enfin dune manière préférée les programmes sont établis de telle sorte que, dans la mesure du possible une impulsion de gradient commence dès qu'une autre se termine : il n'y a pas de temps mort. Les diagrammes 2e et 2g le montrent très clairement : les impulsions sont contigües. En fait ces diagrammes correspondent içi à une expérimentation à temps - d'écho - T - minimum. Si le temps d'écho n'est pas minimum il y a un écart entre la fin des impulsions de codage dephase 18,23,26,29,31 et le début des impulsions de resélection 24,27.

Dans le cas général dune inclinaison quelconque de l'image, l'impulsion de codage de phase est bien entendu aussi répartie, dune manière variable dune séquence à l'autre de la série, en des impulsions variables 41 et 42 sur les autres axes d'imageries.

## Revendications

1. Procédé d'application des impulsions de gradient dans une expérimention d'imagerie au moyen dune machine (1-11) de RMN caractérisé en ce qu'il comporte les étapes suivantes :
   – on choisit des formes communes (18,20,21) pour des impulsoins de gradient, devant être appliquées sensiblement en même temps,
   – on choisit des dates ($t_2,t_5$) communes d'application des diverses impulsions de gradient sur les différents axes (S,C,P,L) de l'image,

– on répartit les impulsons de gradient relatives aux axes (S,C,P,L) de l'image sur les axes d'imagerie (XYZ) de la machine, en fonction des cosinus directeurs de l'axe d'inclinaison (A) de l'image par rapport aux axes d'imagerie de la machine, et suivant une chronologie déterminée par le choix des dates communes.

2. Procédé selon la revendication 1, caractérisé en ce que l'expérimentation d'imagerie comporte l'application dune méthode d'imagerie de type 2DFT, en ce que les axes d'image sont l'axe de sélection, l'axe de codage de phase, et l'axe de lecture et en ce que les axes d'imagerie de la machine sont orthogonaux entre eux, un (Z) de ces axes d'imagerie étant orienté dans le même sens qu'un champ magnétique orientateur (B$_0$) nécessaire pour l'expérimentation.

3. Procédé selon la revendication 2, caractérisé en ce l'application des impulsions de gradient comporte quatre phases types. Une première phase (t$_{-2}$ - t$_2$) de sélection (13) d'image, une deuxième phase (t$_2$ - t$_5$) de rephasage (20) de sélection, de codage (18) de phase, et de précodage (21) de lecture, une troisième phase (t$_5$ - t$_8$) de sélection (16) et une quatrième phase (t$_8$ - t$_9$) de lecture (19), les première et deuxième phases et troisième et quatrième phases étant respectivement contiguës l'une de l'autre dans le temps.

4. Procédé selon l'une quelconque des revendications 1 à 3, caractérisé en ce que l'on choisit une forme générale trapézoïdale pour les impulsions.

5. Procédé selon l'une quelconque des revendications 1 à 3 caractérisé en ce que pour répartir on agit uniquement sur l'amplitude des impulsions.

**Patentansprüche**

1. Verfahren zum Anlegen von Gradientenimpulsen in einem Abbildungsexperiment mittels einer NMR-Maschine (1-11), dadurch gekennzeichnet, daß es die folgenden Schritte umfaßt:
– Wählen von gemeinsamen Formen (18, 20, 21) für Gradientenimpulse, bevor diese im wesentlichen gleichzeitig angelegt werden,
– Wählen von gemeinsamen Zeitpunkten (t$_2$, t$_8$) zum Anlegen verschiedenartiger Gradientenimpulse auf die verschiedenen Achsen (S, C, P, L) des Bildes,
– Verteilen der auf die Achsen (S, C, P, L) des Bildes bezogenen Gradientenimpulse auf die Abbildungsachsen (XYZ) der Maschine in Abhängigkeit vom jeweiligen Richtungskosinus der Neigungsachse (A) des Bildes in bezug auf die Abbildungsachsen der Maschine und gemäß einer zeitlichen Abfolge, die durch die Wahl der gemeinsamen Zeitpunkte festgelegt wird.

2. Verfahren gemäß Anspruch 1, dadurch gekennzeichnet, daß das Abbildungsexperiment die Anwendung eines Abbildungsverfahrens von 2DFT-Typ enthält, daß die Bildachsen die Selektionsachse, die Phasenkodierungsachse und die Leseachse sind und daß die Abbildungsachsen der Maschine untereinander orthogonal sind, wobei eine (Z) der Abbildungsachsen im gleichen Richtungssinn wie ein für das Experiment erforderliches Orientierungsmagnetfeld (B$_0$) orientiert ist.

3. Verfahren gemäß Anspruch 2, dadurch gekennzeichnet, daß die Anlegung der Gradientenimpulse vier Phasentypen umfaßt: eine erste Phase (t$_{-2}$ - t$_2$) zur Bildauswahl (13), eine zweite Phase (t$_2$ - t$_5$) zur Phasen-Resynchronisation (20) der Selektion, zur Phasenkodierung (18) und zur Lese-Vorkodierung (21), eine dritte Phase (t$_5$ - t$_8$) zur Selektion (16) und eine vierte Phase (t$_8$ - t$_9$) zum Lesen (19), wobei die erste und die zweite Phase und die dritte und die vierte Phase in der Zeit jeweils aneinandergrenzen.

4. Verfahren gemäß einem der Ansprüche 1 bis 3, dadurch gekennzeichnet, daß für die Impulse die allgemeine Form eines Trapezes gewählt wird.

5. Verfahren gemäß einem der Ansprüche 1 bis 3, dadurch gekennzeichnet, daß zum Verteilen nur auf die Amplitude der Impulse eingwirkt wird.

**Claims**

1. A method for the application of gradient pulses in an imaging test by means of an NMR apparatus (1-11), characterized in that it comprises the following steps:
– the selection of the common forms (18, 20 and 21) for the gradient pulses which are to be applied substantially simultaneously,
– the selection of dates (t$_2$ and t$_5$) common for the application of the various gradient pulses on the different axes (S, C, P and L) of the image,
– the distribution of the gradient pulses in relation to axes (S, C, P and L) of the image on the imaging axes (XYZ) of the apparatus as a function of the cosine directors of the axis of slope (A) of the image in relation to the imaging axes of the apparatus and following dates set by the selection of the common dates.

2. The method as claimed in claim 1, characterized in that the imaging test comprises the application of an imaging method of the 2DFT type, in that the axes of the image are the selection axis, the axis of phase encoding and the read axis and in that the imaging axes of the apparatus are at right angles to each other, one axis (Z) of these imaging axes being orientated in the same direction as an orientating magnetic field (B$_0$) necessary for the test.

3 The method as claimed in claim 2, characterized in that the application of the gradient pulses comprises four phase types: a first phase ($t_{-2}$ - $t_2$) for the selection (13) of the image, a second phase ($t_2$ - $t_5$) for selection rephasing (20), phase encoding (18), and read pre-encoding (21), a third selection (16) phase ($t_5$ - $t_8$) and a fourth reading (19) phase ($t_8$ - $t_9$), the first, second, third and fourth phases respectively adjoining each other in time.

4. The method as claimed in any one of the preceding claims 1 through 3, characterized in that a generally trapezoidal form is selected for the pulses.

5. The method as claimed in any one of the preceding claims 1 through 3, characterized in that in order to perform distribution action is only taken on the amplitude of the pulses.

# FIG_1

EP 0 277 165 B1

# FIG_2